# EUROPEAN PATENT APPLICATION

(11) **EP 1 990 917 A1**
(43) Date of publication of application: **12.11.2008**
(21) Application number: 07107949.5
(22) Date of filing: 10.05.2007
(51) Int. Cl.: H03M 1/06, H03M 1/12, H03M 1/36

(54) **Analog-to-digital converter**

(71) Applicant: Septentrio N.V., 3001 Leuven (BE)
(72) Inventor: De Wilde, Wim, 3010 Kessel-Lo (BE); Koitsalu, Evald, 1348 Louvain la Neuve (BE)
(74) Representative: pronovem

(57) **Abstract**

The present invention is related to an analogue-to-digital converter circuit (1) for digitizing an analogue voltage signal. It comprises a first input (2) for applying the analogue voltage signal and at least one LVDS receiver (3) arranged for being fed with a first signal derived from the analogue voltage signal at the first input and with a second signal, whereby said second signal is a reference signal or a further signal derived from the analogue voltage signal. The at least one LVDS receiver is further arranged for making a comparison of the first and second signal and for providing a digital output signal based on that comparison. The digital output signal is a digital representation of at least a part of said analogue voltage signal.

## Description

### Field of the invention

The present invention relates to analog-to-digital converters suitable for wideband spread spectrum systems.

### State of the art

An analog-to-digital converter (abbreviated ADC or A/D) is an electronic circuit that converts continuous signals to discrete digital numbers. Typically, an ADC is an electronic device that converts an input analog voltage to a digital number. The digital output may be using different coding schemes, such as binary and two's complement binary.

The resolution of the converter indicates the number of discrete values it can produce over the range of voltage values. It is usually expressed in bits. For example, an ADC that encodes an analog input to one of 256 discrete values (0 ... 255) has a resolution of eight bits, since 2⁸ equals 256. Resolution can also be defined electrically, and expressed in volts. The voltage resolution of an ADC is equal to its overall voltage measurement range divided by the number of discrete values.

The required resolution of an ADC is set by the expected environmental noise. The quantization step should be small compared to this noise. In most systems (audio, telecom, ...) resolutions around 10 bit are required for proper system performance. In some systems, like wideband spread spectrum systems (e.g. GPS), the signal is dominated by noise. For these systems a resolution of 1 to 2 bits is already sufficient.

Low resolution ADCs at speeds suitable for wideband spread spectrum systems (1-100 MHz) are generally not available on the market. This is usually overcome in the following ways :
- A higher resolution (8 bits or more) ADC is implemented. Only a few bits are effectively used.
   This drastically increases board space and power consumption (order of magnitude 100 mW) of the system.
- The ADC is integrated in an ASIC. This involves analogue or mixed chip development and costs a lot of money. As a result this is only used in chipsets that target a very large market.
- The ADC is made by means of discrete comparators. The drawback is that commercially available high-speed comparators have a significant package size and often high power consumption.

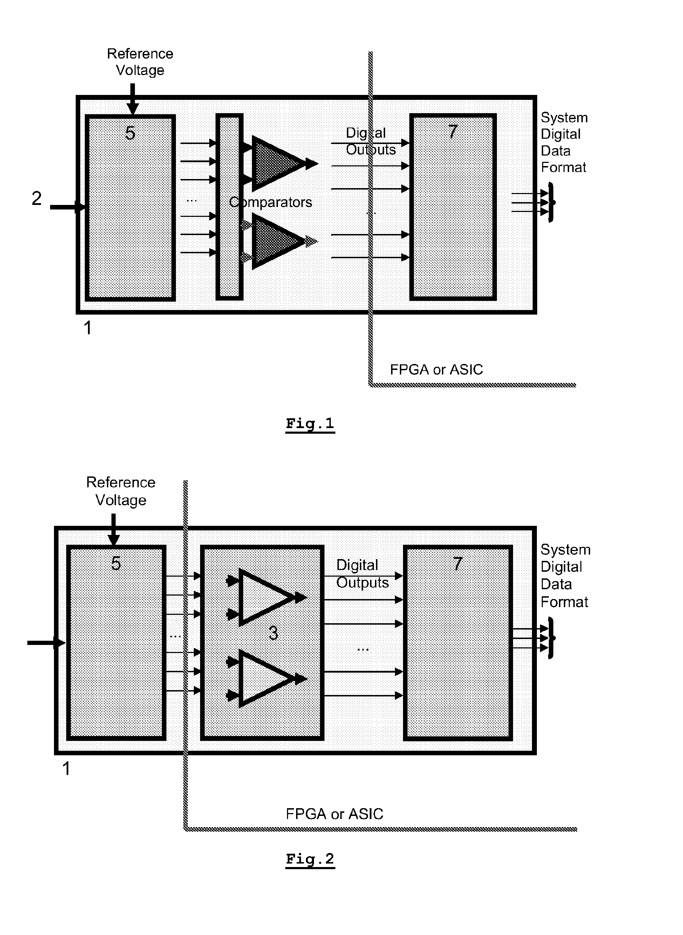

Fig.1 shows a block scheme of a discrete comparator A/D converter as known in the prior art. The analogue signal to be converted is usually first applied to an analogue conditioning circuit (5) for creating scaled and shifted versions of the input and reference signal. The resulting signals are next fed to a bank of comparators. The comparator bank feeds a logic circuit (7) that generates a code for each voltage range.

Low-voltage differential signalling (LVDS) uses high-speed analogue circuit techniques to provide multigigabit data transfers on copper interconnects and is a generic interface standard for high-speed data transmission. LVDS's proven speed, low power, noise control, and cost advantages are popular in point-to-point applications for telecommunications, data communications, and displays.

LVDS is a differential signaling system, meaning that it transmits two different voltages which are compared at the receiver. LVDS uses this difference in voltage between the two wires to encode information. The transmitter injects a small current, nominally 3.5 mA, into one wire or the other, depending on the logic level to be sent. The current passes through a resistor of about 100 to 120 Ohm (matched to the characteristic impedance of the cable) at the receiving end and then returns in the opposite direction along the other wire. From Ohm's law, the voltage difference across the resistor is therefore about 350 mV. The receiver senses the polarity of this voltage to determine the logic level. This type of signaling is called a current loop.

The low common-mode voltage (the average of the voltages on the two wires) of about 1.25 V allows LVDS to be used with a wide range of integrated circuits with power supply voltages down to 2.5 V or lower. The low differential voltage, about 350 mV as stated above, causes LVDS to consume very little power as compared to other systems. For example, the static power dissipation in the LVDS load resistor is 1.2 mW. This figure should be compared to the 90 mW dissipated by the load resistor for an RS-422 signal. Without a load resistor the whole wire has to be loaded and unloaded for every bit of data. Using high frequencies and a load resistor so that a single bit only covers a part of the wire (while traveling near light speed) is more power efficient.

### Aims of the invention

The present invention aims to provide a low resolution A/D converter operable at a speed suitable for wideband spread spectrum systems.

### Summary of the invention

The present invention relates to an A/D converter circuit for digitizing an analogue voltage signal. The circuit comprises a first input for applying the analogue voltage signal and at least one LVDS receiver arranged for being fed with a first signal derived from the analogue voltage signal at the first input and with a second signal, said second signal being a reference signal or a further signal derived from the analogue voltage signal. The at least one LVDS receiver is further arranged for making a comparison of the first and second signal and for providing a digital output signal based on said comparison. The digital output signal is a digital representation of at least a part of the analogue voltage signal. Preferably the A/D converter circuit comprises more than one LVDS receiver.

In a preferred embodiment the A/D converter circuit further comprises a digital conversion circuit for converting the digital output signal of the at least one LVDS receiver to a predetermined data format for further processing. In this case more than one LVDS receiver is employed.

In another preferred embodiment the A/D converter circuit further comprises a second input for applying an external voltage reference signal.

The analogue voltage signal is advantageously a differential signal. Alternatively, it may be a single-ended signal.

In another advantageous embodiment the A/D circuit further comprises a latching circuit for latching the digital output signals of the at least one LVDS receiver.

In a further embodiment the A/D converter circuit comprises analogue conditioning circuitry for scaling the analogue voltage signal or an applied external voltage reference signal.

In a second aspect the present invention also relates to an integrated circuit as previously described. Advantageously, such integrated circuit further comprises processing means for further digital processing.

### Short description of the drawings

Fig. 1 represents a prior art A/D converter.

Fig. 2 represents an A/D converter according to the present invention.

Fig. 3 represents a practical implementation of a two bit differential A/D converter using LVDS receivers.

Fig. 4 represents a differential A/D converter with multiple magnitude levels.

### Detailed description of the invention

Employing an A/D converter implies the use of a digital component to generate a digital representation of the applied analogue signal. In many systems this digital component is a configurable digital integrated circuit (Field Programmable Gate Array, FPGA) or a (semi-)custom digital ASIC. Most FPGAs and digital ASIC libraries include I/O buffers operating according to the Low Voltage Differential Signaling (LVDS) standard.

The solution according to the present invention proposes to use at least one LVDS receiver (in practice most often more than one) to construct an A/D converter. This is possible since an LVDS receiver acts as a comparator with limited operating range. As a consequence circuits known to construct ADCs by comparators can be implemented with LVDS receivers.

Fig. 2 represents a block scheme of an A/D converter according to the present invention. An analogue voltage signal is applied via input (2) to the A/D converter (1). The comparators of the prior art ADC have been replaced by at least one LVDS receiver (3). The LVDS receiver receives at its input the analogue signal to be digitized and a reference signal. This reference signal can be an external reference signal, possibly applied via a 'dedicated' input or via the power supply. Alternatively, the reference signal can also be a further signal derived from the analogue voltage signal at the input of the ADC. It can for example be based on the average level, the common mode level or the power of the input signal.

The applied analogue signal can be a single-ended signal or, preferably, a differential signal.

An LVDS receiver can be used for determining the sign of an analogue differential voltage. This effectively corresponds to a single bit quantization. The applied signal should possibly be scaled and/or shifted by means of a simple passive network such that it falls within the LVDS common-mode and differential operating range. This conditioning circuitry (5) is shown in Fig.2.

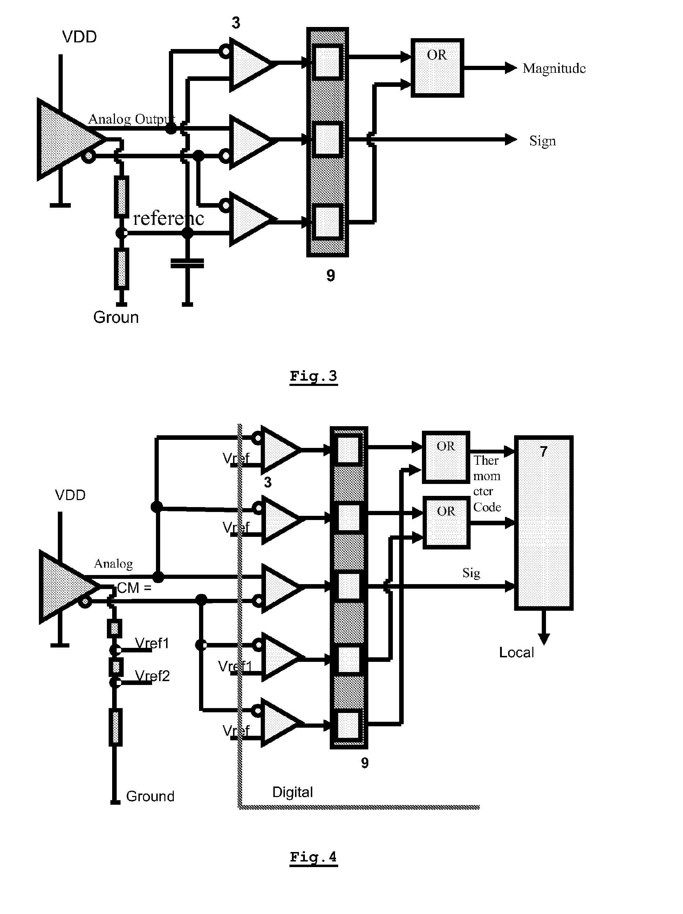

A differential multi-bit ADC can be realized as shown in Fig.3. One LVDS receiver is still used for sign determination (the central one). The other two LVDS receivers connect with either the positive or the negative differential node at one terminal and a fixed voltage offset with respect to the common mode voltage at the other terminal. Whenever the magnitude of the differential input voltage exceeds twice this offset voltage, this is reflected in the state of one of these two LVDS receivers. In the example of Fig.3 the offset voltage results from a resistive divider between the common-mode level available at the output buffer and ground. The voltage that sets the original common mode voltage should be considered as primary reference input. Often this is the power supply. The outputs of the two LVDS receivers that sense the magnitude in the example are combined via an OR-gate towards a magnitude bit. In this way the output of this digital conversion circuit has the sign/magnitude format used in many GPS receivers. The skilled person readily understands that alternative implementations of such a digital conversion circuit can be envisaged. Note that the output of each of the LVDS receivers is preferably latched with a latching circuit (9) prior to processing in the OR-gate. This is in order to avoid sampling delay between the different bits, which would lead to distortion.

In case the magnitude of an analogue input voltage is quantized, the voltage should be connected to one terminal of the LVDS receiver, while the other terminal should be connected to a reference voltage. This reference voltage should be such that the average of the latter and the input signal is within the limits of the operating range of the common-mode voltage of the LVDS receiver. If multiple LVDS receivers are used with different reference voltage, the input voltage can be estimated from a thermometer code, wherein the number of ones in the converted signal represents the decimal value. Usually a digital conversion circuit is needed to convert this thermometer code into a manageable format for further processing, like a sign/magnitude format, two's complement or offset binary format. This is further clarified in Fig.4.

The invention further also relates to an integrated circuit comprising the A/D conversion circuit as previously described. As LVDS receivers are standard features of most state-of-the-art FPGAs and digital ASIC technologies, the whole A/D converter except the analogue conditioning circuit can advantageously be integrated on an FPGA or digital ASIC. The integrated circuit may further comprise processing means for further digital processing, such as digital signal conditioning, spread spectrum digital demodulators and/or a digital signal processor.

The advantage of the integrated approach as compared to the prior-art implementation based on external discrete comparators or on a COTS A/D converter mainly lies in a reduced system footprint and reduced cost.

## Claims

1. Analogue-to-digital converter circuit (1) for digitizing an analogue voltage signal, comprising a first input (2) for applying said analogue voltage signal and at least one LVDS receiver (3) arranged for being fed with a first signal derived from said analogue voltage signal at said first input and with a second signal, said second signal being a reference signal or a further signal derived from said analogue voltage signal, said at least one LVDS receiver further being arranged for making a comparison of said first and second signal and for providing a digital output signal based on said comparison, said digital output signal being a digital representation of at least a part of said analogue voltage signal.

2. A/D converter circuit as in claim 1, further comprising a digital conversion circuit (7) for converting said digital output signal of said at least one LVDS receiver to a predetermined data format for further processing.

3. A/D converter circuit as in claim 1 or 2, further comprising a second input for applying an external voltage reference signal.

4. A/D converter circuit as in any of claims 1 to 3, whereby said analogue voltage signal is a single-ended signal.

5. A/D converter circuit as in any of claims 1 to 3, wherein said analogue voltage signal is a differential signal.

6. A/D converter circuit as in any of the previous claims, further comprising a latching circuit (9) for latching said digital output signals of said at least one LVDS receiver.

7. A/D converter circuit as in any of the previous claims, further comprising analogue conditioning circuitry (5) for scaling said analogue voltage signal or said external voltage reference signal.

8. Integrated circuit comprising an A/D converter circuit as in any of claims 1 to 6.

9. Integrated circuit as in claim 8, further comprising processing means for further digital processing.
